(19) **Europäisches Patentamt / European Patent Office / Office européen des brevets**

(11) **EP 4 502 947 A1**

(12) **EUROPEAN PATENT APPLICATION**
published in accordance with Art. 153(4) EPC

(43) Date of publication:
**05.02.2025 Bulletin 2025/06**

(21) Application number: **23814624.5**

(22) Date of filing: **18.01.2023**

(51) International Patent Classification (IPC):
***G06T 7/70*** (2017.01)

(52) Cooperative Patent Classification (CPC):
**G06F 30/13; G06T 7/70**

(86) International application number:
**PCT/CN2023/073002**

(87) International publication number:
**WO 2023/231425 (07.12.2023 Gazette 2023/49)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **31.05.2022 CN 202210608266**

(71) Applicant: **ZTE Corporation**
**Shenzhen, Guangdong 518057 (CN)**

(72) Inventors:
- **CHEN, Dawei**
  **Shenzhen, Guangdong 518057 (CN)**
- **CHEN, Shijun**
  **Shenzhen, Guangdong 518057 (CN)**
- **LI, Junqiang**
  **Shenzhen, Guangdong 518057 (CN)**

(74) Representative: **Carangelo, Pierluigi et al**
**Jacobacci & Partners S.p.A.**
**Via Tomacelli 146**
**00186 Roma (IT)**

(54) **POSITIONING METHOD, ELECTRONIC DEVICE, STORAGE MEDIUM AND PROGRAM PRODUCT**

(57) Disclosed in the present application are a positioning method, an electronic device, a storage medium and a program product. The positioning method comprises: acquiring a reference image in which a target to be positioned and at least one target reference object are displayed, acquiring first position information of the target reference object in the reference image, and acquiring relative position information of said target in the reference image relative to the target reference object; acquiring second position information of the target reference object in a pre-generated indoor image; and determining target position information of said target in the indoor image according to the first position information, the relative position information and the second position information.

FIG. 1

S110 — Acquire a reference image displaying both a target to be positioned and at least one target reference object, acquire first position information about the target reference object in the reference image, and acquire relative position information about the target to be positioned relative to the target reference object in reference image

S120 — Acquire second position information about the target reference object in a pre-generated indoor image

S130 — Determine target position information about the target to be positioned in the indoor image according to the first position information, the relative position information, and the second position information

**Description**

**CROSS-REFERENCE TO RELATED APPLICATION**

This application is based on and claims the priority of Chinese patent application No. 202210608266.9 filed on May 31, 2022, the disclosure of which is incorporated herein by reference in its entirety.

**TECHNICAL FIELD**

The present disclosure relates to the field of positioning technologies, in particular to a method for positioning, an electronic device, a computer storage medium, and a computer program product.

**BACKGROUND**

With the large-scale commercialization of 5G and the rapid development of mobile Internet, indoor positioning based on 5G base stations has received more and more attention. In order to obtain high-precision positioning effect, indoor positioning requires accurate mapping of location coordinates of a positioning base station, without considering the specific positioning technology. However, due to the severe obstruction in an indoor environment and the large attenuation of signal propagation, even a small error in a base station's location will lead to a large positioning error. Further, indoor positioning base stations are often located in indoor ceilings, wall lines, columns or other places which are not easily touched, making them difficult to be directly measured. Additionally, the base station may also be blocked by other object(s), which further complicates positioning measurement. Moreover, a layout of items in an indoor scene may change, which involves frequent corrections of the base station's location and will bring a large workload for each re-measurement. Therefore, it can be learned that the above factors can all affect the accuracy of positioning results of the base station's location. Current base station calibration devices include laser rangefinders, total stations, etc. These instruments need to be repeatedly calibrated before being used in a specific scenario, and users need to have a detailed understanding of use performance of the instruments, which results in an additional workload.

**SUMMARY**

Embodiments of the present disclosure provide a method for positioning, an electronic device, a computer storage medium, and a computer program product, which can effectively reduce a workload of positioning a target and improve the accuracy of a positioning result.

In accordance with a first aspect of the present disclosure, an embodiment provides a method for positioning, which includes:

- acquiring a reference image displaying both a target to be positioned and at least one target reference object, acquiring first position information about the target reference object in the reference image, and acquiring relative position information about the target to be positioned relative to the target reference object, in the reference image;

- acquiring second position information about the target reference object in a pre-generated indoor image; and

- determining target position information about the target to be positioned in the indoor image according to the first position information, the relative position information, and the second position information.

In accordance with a second aspect of the present disclosure, an embodiment further provides an electronic device, which includes: at least one processor; and at least one memory for storing at least one program, where the at least one program, when executed by the at least one processor, causes the processor to carry out the method described above.

In accordance with a third aspect of the present disclosure, an embodiment further provides a computer-readable storage medium storing a processor-executable program which, when executed by a processor, causes the processor to carry out the positioning described above.

In accordance with a fourth aspect of the present disclosure, an embodiment further provides a computer program product, which includes a computer program or computer instructions stored in a computer-readable storage medium, from which a processor of a computer device reads the computer program or the computer instructions, where the computer program or the computer instructions, when executed by the processor, cause the computer device to carry out the method described above.

In the embodiments of the present disclosure, without using other special positioning devices and considering effect of the layout in an indoor environment, indoor positioning can be realized only by acquiring the reference image displaying both the target to be positioned and the at least one target reference object and the pre-generated indoor image, which can greatly reduce a workload of the indoor positioning. To be specific, matching is performed on the reference image and the indoor image, to obtain reference mapping information between the target reference object in the reference image and the target reference object in the indoor image by acquiring the first position information about the target reference object in the reference image and the second position information about the target reference object in the indoor image, such that the target position information about the target to be positioned in the indoor image is accurately acquired based on the reference mapping information and the determined relative position information about the target to be positioned in the reference image relative to the target reference object. Therefore, according to the embodiments of the present disclosure, it is possible to effectively reduce the workload of positioning a target and improve the accuracy of a positioning result. This fills the technical gap in a related method.

## BRIEF DESCRIPTION OF DRAWINGS

FIG. 1 is a flowchart of a method for positioning according to an embodiment of the present disclosure;

FIG. 2 is a flowchart of acquiring a reference image displaying both a target to be positioned and at least one target reference object in a method for positioning according to an embodiment of the present disclosure;

FIG. 3 is a flowchart of obtaining a reference image displaying a target to be positioned and a target reference object in a method for positioning according to embodiment of the present disclosure;

FIG. 4 is a flowchart of acquiring relative position information about a target to be positioned in a reference image relative to a target reference object in a method for positioning according to an embodiment of the present disclosure;

FIG. 5 is a flowchart of generating an indoor image in a method for positioning according to an embodiment of the present disclosure;

FIG. 6 is a flowchart of determining target position information about a target to be positioned in an indoor image through geometric calculation in a method for positioning according to an embodiment of the present disclosure;

FIG. 7 is a flowchart of determining target position information about a target to be positioned in an indoor image through geometric calculation in a method for positioning according to another embodiment of the present disclosure;

FIG. 8 is a schematic diagram of an application scenario of a method for positioning according to an embodiment of the present disclosure;

FIG. 9 is a schematic diagram of an application scenario of a method for positioning according to another embodiment of the present disclosure;

FIG. 10 is a flowchart of a method for positioning according to another embodiment of the present disclosure;

FIG. 11 is a flowchart of acquiring resultant position information about a target to be positioned in an indoor image in a method for positioning according to an embodiment of the present disclosure;

FIG. 12 is an execution flowchart of a method for positioning according to an embodiment of the present disclosure; and

FIG. 13 is a schematic diagram of an electronic device according to an embodiment of the present disclosure.

## DETAILED DESCRIPTION

In order to make the objectives, technical schemes and advantages of the present disclosure more apparent, the present disclosure is further described in detail with reference to the accompanying drawings and embodiments. It should be understood that the particular embodiments described herein are only intended to explain the present disclosure, and are not intended to limit the present disclosure.

It is to be noted that although a logical order is shown in the flowcharts, the operations shown or described may be performed, in some cases, in a different order from the order shown or described in the flowcharts. The terms such as "first" and "second" in the description, claims and above-mentioned drawings are intended to distinguish between similar objects and are not necessarily to describe a specific order or sequence.

The present disclosure provides a method for positioning, an electronic device, a computer storage medium, and a computer program product. According to an embodiment, the method includes: acquiring a reference image displaying a target to be positioned and at least one target reference object, acquiring first position information about the target reference object in the reference image, and acquiring relative position information about the target to be positioned in the reference image relative to the target reference object; acquiring second position information about the target reference object in a pre-generated indoor image; and determining target position information about the target to be positioned in the indoor image according to the first position information, the relative position information, and the second position information. In this embodiment, without using other special positioning devices and considering effect of the layout of an indoor environment, indoor positioning can be realized only by acquiring the reference image displaying both the target to be positioned and the at least one target reference object and the pre-generated indoor image, which can greatly reduce a workload of the indoor positioning. To be specific, matching is performed on the reference image and the indoor image, to obtain reference mapping information between the target reference object in the reference image and the target reference object in the indoor image by acquiring the first position information about the target reference object in the reference image and the second position information about the target reference object in the indoor image, so that the target position information about the target to be positioned in the indoor image is accurately acquired based on the reference mapping information and the determined relative position information about the target to be positioned in the reference image relative to the target reference object. Therefore, according to various embodiments of the present disclosure, it is possible to effectively reduce the workload of positioning a target and improve the accuracy of a positioning result. This fills the technical gap in a related method.

Several embodiments of the present disclosure will be further illustrated below with reference to the accompanying drawings.

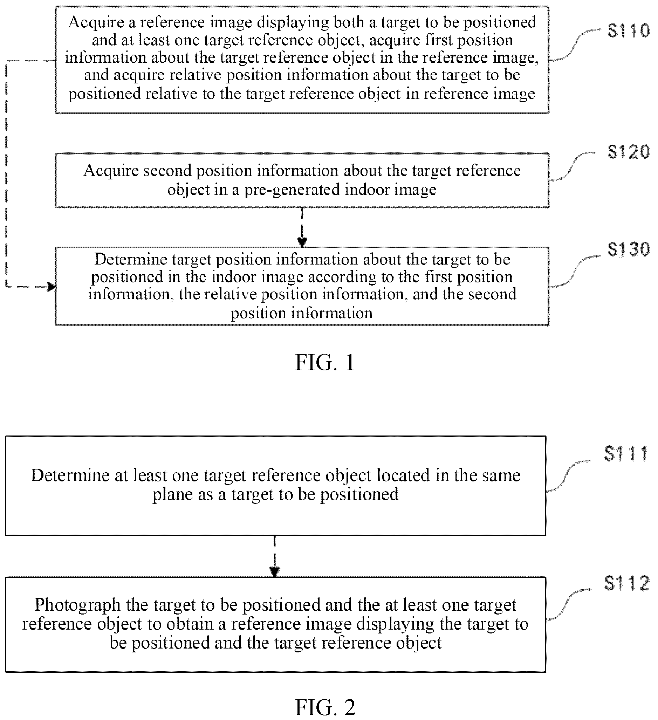

As shown in FIG. 1, a flowchart of a method for positioning according to an embodiment of the present disclosure is depicted. The method includes but is not limited to operations S 110 to S 130.

At operation S110, a reference image displaying both a target to be positioned and at least one target reference object is acquired, first position information about a first position of the target reference object in the reference image (interchangeable with the first position information about the target reference object in the reference image) is acquired, and relative position information about the relative position of the target to be positioned relative to the target reference object in the reference image (interchangeable with the relative position information about the target to be positioned relative to the target reference object) is acquired.

In this operation, by acquiring the reference image displaying both the target to be positioned and the at least one target reference object, the first position information about the target reference object in the reference image is determined from the acquired reference image, and the relative position information about the target to be positioned relative to the target reference object in the reference image is determined from the acquired reference image. In other words, different position information about the target reference object in the reference image can be acquired, such that an indoor position of the target to be positioned can be further determined according to the difference between the position information in a subsequent operation.

In an embodiment, there may be a plurality of types of targets to be positioned, which is not limited herein. For example, the target to be positioned may be, but is not limited to, a base station to be positioned, a transmitting terminal device, an access terminal device, a network controller, a modulator, a serving unit, or the like. When the target to be positioned is a transmitting terminal or an access terminal, it may be, but is not limited to, user equipment (UE), a subscriber unit, a subscriber station, a mobile station, a mobile console, a remote station, a remote terminal, a mobile device, a user terminal, a wireless communication device, a user agent, a user apparatus, or the like.

In an embodiment, a type of the target reference object is not limited herein. For example, the target reference object may be, but is not limited to, a column, a wall corner, a wall line, a door, a window, or the like in indoor space where the target to be positioned is located.

In an embodiment, the number of target reference objects is not limited herein. For example, when one target reference object is determined, only one target reference object needs to be displayed in the acquired reference image. Similarly, when two target reference objects are determined, both target reference objects need to be displayed in the acquired reference image. That is, each of the determined target reference objects needs to be displayed in the acquired reference image.

In an embodiment, there may be various acquisition methods of the reference image or presentation modes of the reference image, which is not limited herein. For example, the reference image may be acquired through photographing, and the reference image in this case is a resulting photograph. In an implementation, during photographing, the target to be positioned and a selected target reference object are included in a photographing frame of a shooting device such as a camera or a mobile phone, such that the target to be positioned and the selected target reference object can be captured and displayed in a resulting photograph. Here, the resulting photograph can be processed by using, but not limited to, an image processing technology, a pattern recognition technology, or the like to extract the first position information about the target reference object in the photograph.

In an embodiment, the first position information may be presented in various forms, which is not limited herein. For example, the first position information may be physical coordinate information about the target reference object in the reference image. The physical coordinate information here refers to coordinate information about the target reference object in a world coordinate system, that is, absolute coordinates of the target reference object in the world coordinate system. For another example, the first position information may be pixel coordinate information about the target reference object in the reference image, and the pixel coordinate information here refers to coordinate information about the target reference object in a reference image coordinate system, that is, relative coordinates of the target reference object in the reference image coordinate system. In case that the coordinate information about the reference image in the world coordinate system is determined, the pixel coordinate information about the target reference object in the reference image may be converted into the physical coordinate information about the target reference object in the reference image accordingly. In other words, the first position information may be presented in various forms in specific application scenarios, and those having ordinary skill in the art may select a corresponding presentation of the first position information according to a specific application scenario.

In an embodiment, the relative position information may be presented in various forms, which is not limited herein. For example, the relative position information may be a distance between the target reference object and the target to be positioned, where the distance here is a relative distance between the target reference object and the target to be positioned in the reference image. For another example, the relative position information may be a relative position of the target reference object relative to a target projection, where the target projection is a projection of the target to be positioned onto the target reference object. For another example, the relative position information may be the distance between the target reference object and the target to be positioned and the relative position of the target reference object relative to the target projection, that is, the relative position information may be represented by a combination of these two relative position relationships.

In an embodiment, the relative position relationships may be determined by using, but not limited to, an image processing technology, a pattern recognition technology, or the like.

As shown in FIG. 2, in one embodiment of the present disclosure, "acquiring a reference image displaying a target to be positioned and at least one target reference object" in operation S 110 is further described, and operation S110 includes, but is not limited to, operations S111 and S112.

At operation S111, at least one target reference object located in the same plane as the target to be positioned is determined.

At operation S112, the target to be positioned and the at least one target reference object are photographed to obtain the reference image displaying both the target to be positioned and the target reference object.

In this operation, by determining the at least one target reference object located in the same plane as the target to be positioned, it is convenient to take a photograph of the target to be positioned and the at least one target reference object. In other words, since the target to be positioned and the target reference object are in the same plane and there is no plane difference between them, during photographing of the target to be positioned and the target reference object, the two can be easily included in a photographing range by simplified lens photographing. As such, a photograph meeting a requirement is taken within the photographing range to obtain the reference image displaying the target to be positioned and the target reference object.

In an embodiment, since the target to be positioned and the target reference object are in the same plane, physical coordinates of the target to be positioned and the target reference object are in the same level, that is, positions of the two do not differ in spatial dimensions.

As a result, it is convenient to accurately and reliably calculate target position information about the target to be positioned in an indoor image geometrically in a subsequent operation.

In an embodiment, there may be more relative spatial relationships between the target to be positioned and the target reference object, which may be set by those having ordinary skill in the art according to a specific scenario. This is not limited herein.

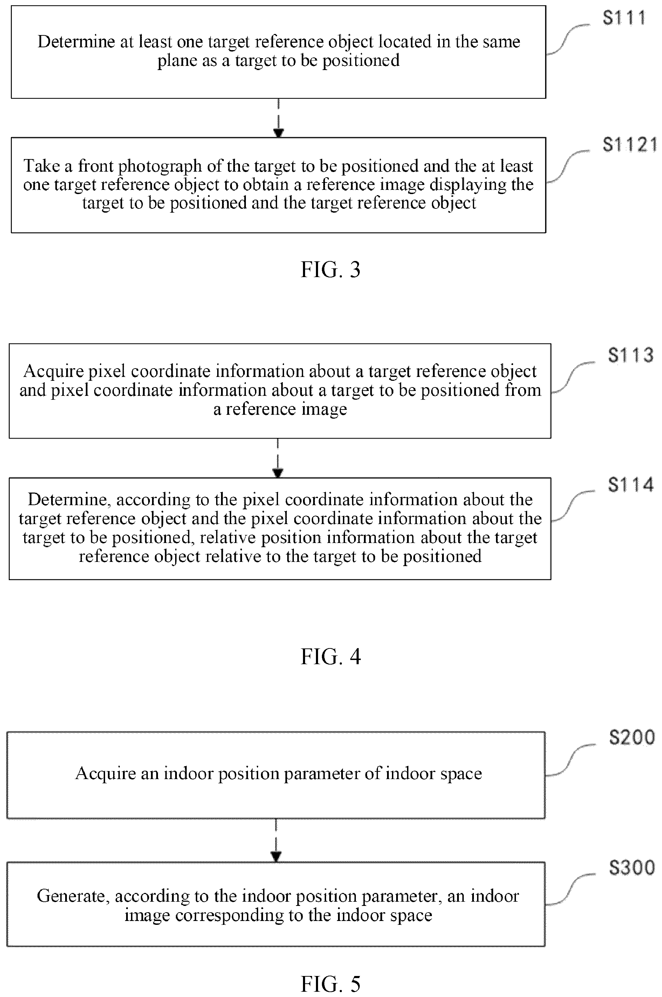

As shown in FIG. 3, in an embodiment of the present disclosure, operation S 112 is further described. Operation S 112 includes, but is not limited to, operation S1121.

At operation S1121, a front photograph of the target to be positioned and the at least one target reference object is taken to obtain the reference image displaying both the target to be positioned and the target reference object.

In this operation, by taking a front photograph of the target to be positioned and the at least one target reference object, the reference image capable of intuitively displaying the target to be positioned and the target reference object can be obtained. In other words, a front photograph (including details that may not be easily noticed) allows for a more complete presentation of the target to be positioned and the target reference object in their entireties, so that when the reference image is subsequently analyzed to obtain relevant position information parameters, such as the first position information and the relative position information, high resolution accuracy is ensured, which is beneficial to obtaining more accurate position information parameters therefrom.

In an embodiment, there may be more angles and methods of taking a photograph of the target to be positioned and the target reference object, for example, photographs are taken from various sides, a specified angle, or the like, or those having ordinary skill in the art may select an angle and a method of taking a photograph of the target to be positioned and the target reference object according to a specific application scenario, which is not limited herein.

As shown in FIG. 4, in one embodiment of the present disclosure, "acquiring relative position information about the target to be positioned in the reference image relative to the target reference object " in operation S110 is further described, and operation S110 includes, but is not limited to, operations S113 and S114.

At operation S113, pixel coordinate information about the target reference object and pixel coordinate information about the target to be positioned are acquired from the reference image.

At operation S114, relative position information about the target reference object relative to the target to be positioned is determined according to the pixel coordinate information about the target reference object and the pixel coordinate information about the target to be positioned.

In this operation, the pixel coordinate information about the target reference object and the pixel coordinate information about the target to be positioned are separately obtained from the reference image, so that the relative position information can be determined according to a difference between the pixel coordinate information about the target reference object and the pixel coordinate information about the target to be positioned. Because the pixel coordinate information about the target reference object and the pixel coordinate information about the target to be positioned can be accurately determined. That is, accuracy of the obtained pixel coordinate information is relatively high, accuracy of the relative position information finally determined based on the pixel coordinate information is relatively high.

At operation S120, second position information about a second position of the target reference object in a pre-generated indoor image (interchangeable with the second position information about the target reference object in a pre-generated indoor image) is acquired.

In this operation, the indoor image is an image corresponding to an indoor space, which may be, but is not limited to, a Computer Aided Design (CAD) drawing, a Pro/Engineer drawing, or other two-dimensional or three-dimensional drawings, that is, an actually presented image of the indoor space, and the indoor image is generated in advance. Therefore, the second position information about the target reference object in the pre-generated indoor image can be acquired from the indoor image, such that the second position information can be further compared with the first position information in a subsequent operation.

In an embodiment, the indoor image may be generated or rendered in various manners, which is not limited herein. For example, as shown in FIG. 5, the indoor image may be generated based on, but not limited to, operations S200 and S300 below.

At operation S200, an indoor position parameter of an indoor space is acquired.

At operation S300, the indoor image corresponding to the indoor space is generated according to the indoor position parameter.

In this operation, because the indoor position parameter is a position parameter associated with the indoor space, an overall layout of the indoor space can be determined by acquiring the indoor position parameter of the indoor space. Thereby, the indoor image corresponding to the indoor space can be accurately generated according to the indoor position parameter. Thus, the second position information about the target reference object in the indoor image can be determined according to the generated indoor image.

In an embodiment, operation S300 may be performed by using, but not limited to, two-dimensional or three-dimensional CAD drawing software to generate an indoor image which meets a requirement; other drawing software having similar functions to the CAD drawing software may alternatively be used for drawing, which is not limited herein.

In an embodiment, there may be a plurality of types of the indoor position parameters, which is not limited herein. For example, the indoor position parameter includes at least one of:

- a wall line position parameter;

- a door position parameter;

- a stand column position parameter; or

- a wall position parameter.

In an embodiment, there may be a plurality of different indoor position parameters, which reflect different aspects of the indoor space. For position parameters in a specific scene, one or more of the position parameters may be selected as a whole of the indoor position parameters according to an actual situation, for example, position parameters of large objects such as indoor wall lines, wall corners, stand columns, doors, windows, etc. can be selected to draw the indoor image, which is not limited herein.

In an embodiment, the second position information may be presented in various forms, which is not limited herein. For example, the second position information may be physical coordinate information about the target reference object in the indoor image, and the physical coordinate information here refers to the coordinate information about the target reference object in the world coordinate system, that is, the absolute coordinates of the target reference object in the world coordinate system. For another example, the second position information may be pixel coordinate information about the target reference object in the indoor image, and the pixel coordinate information here refers to coordinate information about the target reference object in an indoor image coordinate system, that is, relative coordinates of the target reference object in the indoor image coordinate system. In case that the coordinate information about the indoor image in the world coordinate system is determined, the pixel coordinate information about the target reference object in the indoor image may be converted into the physical coordinate information about the target reference object in the indoor image accordingly. In other words, the second position information may be presented in various forms in specific application scenarios, and those having ordinary skill in the art may select a corresponding presentation of the second position information according to a specific application scenario.

In an embodiment of the present disclosure, before operation S110, the method further includes, but is not limited to, operation S 140.

At operation S 140, at least one target reference object is selected in the indoor image.

In this operation, because the indoor image is generated in advance, at least one required target reference object can also be selected in advance in the indoor image, so that it is not necessary to reselect the target reference object or select another target reference object during subsequent acquisition of the reference image. Therefore, a workload of acquiring the reference image can be reduced, that is, it is beneficial to more efficiently and reliably acquiring a reference image which meets the requirement.

At operation S 130, target position information about the target to be positioned in the indoor image is determined according to the first position information, the relative position information, and the second position information.

In this operation, indoor positioning can be realized only by acquiring the reference image displaying the target to be positioned and the at least one target reference object and the pre-generated indoor image without using other special positioning devices and considering effect of the layout of an indoor environment, , which can greatly reduce a workload of the indoor positioning. To be specific, matching is performed on the reference image and the indoor image, to obtain reference mapping information between the target reference object in the reference image and the target reference object in the indoor image by acquiring the first position information about the target reference object in the reference image and the second position information about the target reference object in the indoor image. Thereby, the target position information about the target to be positioned in the indoor image is accurately acquired based on the reference mapping information and the determined relative position information about the target to be positioned relative to the target reference object in the reference image. Therefore, this embodiment of the present disclosure can effectively reduce the workload of positioning a target and improve the accuracy of a positioning result. This fills the technical gap in a related method.

In an embodiment, the target position information may be presented in various forms, which is not limited herein. For example, the target position information may be physical coordinate information about the target to be positioned in the indoor image, and the physical coordinate information here refers to coordinate information about the target to be positioned in the world coordinate system, that is, absolute coordinates of the target to be positioned in the world coordinate system. For another example, the target position information may be pixel coordinate information about the target to be positioned in the indoor image, and the pixel coordinate information here refers to coordinate information about the target to be positioned in the indoor image coordinate system, that is, relative coordinates of the target to be positioned in the indoor image coordinate system. In case that the coordinate information about the indoor image in the world coordinate system is determined, the pixel coordinate information about the target to be positioned in the indoor image may be converted into the physical coordinate information about the target to be positioned in the indoor image accordingly, so that an actual position of the target to be positioned in the indoor image can be more accurately determined, which facilitates possible repair and replacement of the target to be positioned. In other words, the target position information may be presented in various forms in specific application scenarios, and those having ordinary skill in the art may select a corresponding presentation of the target position information according to a specific application scenario.

In an embodiment of the present disclosure, operation S130 is further described. Operation S130 includes but is not limited to operation S131.

At operation S131, the target position information about the target to be positioned in the indoor image is determined through geometric calculation according to the first position information, the relative position information, and the second position information.

In this operation, as the first position information, the relative position information, and the second position information respectively indicate geometric positions of the target to be positioned, between the target to be positioned and the target reference object, and the target reference object, geometric calculation can be used to further determine the target position information about the target to be positioned in the indoor image by calculating the geometric positions.

In an embodiment, a specific means of geometric calculation is not limited, and those having ordinary skill in the art can select a calculation means according to an actual application scenario. For example, each piece of position information is input into a preset geometric calculation program, and a result of the target position information about the target to be positioned in the indoor image is output through the geometric calculation program. For another example, an external human operator sets a corresponding geometric calculation method or the like according to the acquired position information.

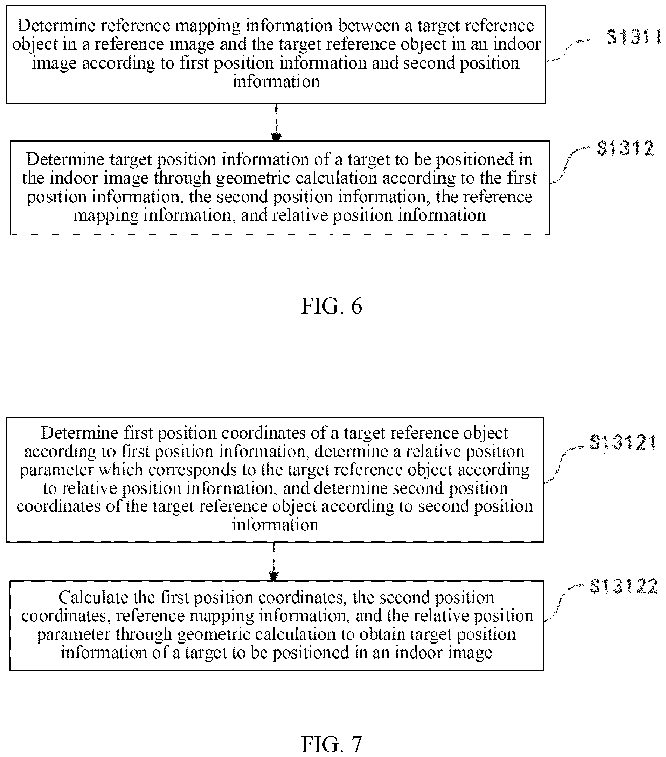

As shown in FIG. 6, in an embodiment of the present disclosure, operation S131 is further described. Operation S131 includes, but is not limited to, operations S1311 and S1312.

At operation S1311, reference mapping information between the target reference object in the reference image and the target reference object in the indoor image is determined according to the first position information and the second position information.

At operation S1312, the target position information about the target to be positioned in the indoor image is determined through geometric calculation according to the first position information, the second position information, the reference mapping information, and the relative position information.

In this operation, because the first position information and the second position information reflect different distinct positions of the target reference object, the reference mapping information between the target reference object in the reference image and the target reference object in the indoor image can be determined according to the first position information and the second position information. Then, the target position information about the target to be positioned in the indoor image can be accurately determined through the geometric calculation according to the first position information, the second position information, the reference mapping information, and the relative position information.

In an embodiment, the reference mapping information includes at least one of:

- scale relationship; or

- projection relationship.

Here, the scale relationship represents a scale at which conversion is performed between the reference image and the indoor image. The projection relationship represents a projection ratio by which conversion is performed between the reference image and the indoor image. It can be understood that there may be more types of reference mapping information. Those having ordinary skill in the art can set other types of reference mapping information with reference to the provision of the reference mapping information described above, which is not limited herein.

As shown in FIG. 7, in an embodiment of the present disclosure, operation S1312 is further described. Operation S1312 includes, but is not limited to, operations S13121 and S13122.

At operation S13121, first position coordinates of the target reference object are determined according to the first position information, a relative position parameter which corresponds to the target reference object is determined according to the relative position information, and second position coordinates of the target reference object are determined according to the second position information.

At operation S13122, geometric calculation is performed based on the first position coordinates, the second position coordinates, the reference mapping information, and the relative position parameter to obtain the target position information about the target to be positioned in the indoor image.

In this operation, an actual position of the target reference object can be obtained by determining the first position coordinates of the target reference object, the relative position parameter corresponding to the target reference object, and the second position coordinates of the target reference object. Thereby, the target position information about the target to be positioned in the indoor image can be accurately calculated based on the actual position of the target reference object, the reference mapping information, and the relative position parameter.

In an embodiment, the first position coordinates may be physical coordinates of the target reference object in the reference image. The physical coordinates here refer to coordinates of the target reference object in the world coordinate system, that is, absolute coordinates of the target reference object in the world coordinate system. For another example, the first position coordinates may be pixel coordinates of the target reference object in the reference image, and the pixel coordinates here refer to coordinates of the target reference object in the reference image coordinate system, that is, relative coordinates of the target reference object in the reference image coordinate system. In case that the coordinates of the reference image in the world coordinate system is determined, the pixel coordinates of the target reference object in the reference image may be converted into the physical coordinates of the target reference object in the reference image accordingly. In other words, the first position coordinates may be presented in various forms in specific application scenarios, and those having ordinary skill in the art may select a corresponding presentation of the first position coordinates according to a specific application scenario.

In an embodiment, the relative position parameter may be presented in various forms, which is not limited herein. For example, the relative position parameter may be a distance parameter between the target reference object and the target to be positioned, may be a relative position parameter of the target reference object relative to the target projection, or the like.

In an embodiment, a second position parameter may be presented in various forms, which is not limited herein. For example, the second position parameter may be physical coordinates of the target reference object in the indoor image, and the physical coordinates here refer to the coordinates of the target reference object in the world coordinate system, that is, the absolute coordinates of the target reference object in the world coordinate system. For another example, the second position parameter may be pixel coordinates of the target reference object in the indoor image, and the pixel coordinates here refer to coordinates of the target reference object in the indoor image coordinate system, that is, relative coordinates of the target reference object in the indoor image coordinate system. In case that the coordinate information about the indoor image in the world coordinate system is determined, the pixel coordinates of the target reference object in the indoor image may be converted into the physical coordinates of the target reference object in the indoor image accordingly. In other words, the second position parameter may be presented in various forms in specific application scenarios, and those having ordinary skill in the art may select a corresponding presentation of the second position parameter according to a specific application scenario.

An example embodiment is given below to illustrate an operating principle and procedure of each of the above-described embodiments.

Example Embodiment I:

It should be noted that, in order to illustrate in greater details the method of the embodiments of the present disclosure, a target to be positioned in this example is set as a base station to be positioned in a real indoor positioning environment. The base station to be positioned is considered to be a point for simplicity.

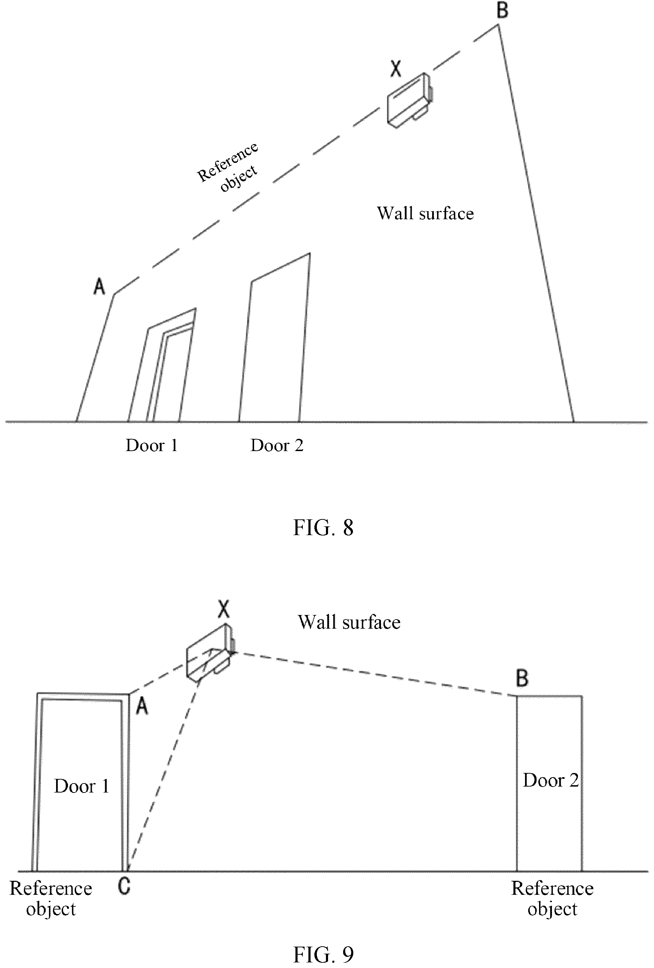

As shown in FIG. 8, in an indoor room, AB is a wall line, and base station X to be positioned is arranged along the wall line AB.

First, indoor CAD drawing is utilized to selectively extract position parameters of an indoor wall line, a stand column, a wall, and the like to draw an indoor map.

Then, the wall line AB along which base station X is located is selected as a reference object, and a camera is set facing and in front of the wall line to take a photograph of base station X. During photographing, it needs to be ensured that the photograph includes base station X and includes the entire wall line AB along which base station X is located. Similarly, since door 1 and door 2 are not served as reference objects, it is not necessary to include door 1 and door 2 in the photograph.

Then, a captured photograph is processed, to be specific, information about the wall line AB in the photograph is extracted. The information is matched with that contained in the indoor map obtained in the first operation, to obtain a mapping relationship between the reference object in the photograph and a reference object in the indoor map. The matching here includes matching reference object information in the photograph and reference object information in the indoor map.

Then, a relative position parameter of base station X relative to the reference object in the photograph is determined, pixel lengths of AX and XB in the

$$\lambda = \frac{|AX|}{|AB|}$$

photograph are obtained, and $\quad$ is defined as the relative position parameter of base station X along the wall line AB.

Then, an actual position of base station X in the indoor map is determined, that is, the actual position of base station X in the indoor map is acquired according to the relative position parameter of base station X relative to the reference object in the photograph and the mapping relationship between the reference object in the photograph and the reference object in the indoor map.

In an embodiment, $A(x_1 y_1)$ and $B(x_2, y_2)$ are given, and according to geometric knowledge, the actual position of base station X to be positioned in the indoor map can be expressed as follows:

$$X_i(x,y) = \left(\frac{x_1 + \lambda x_2}{1 + \lambda}, \frac{y_1 + \lambda y_2}{1 + \lambda}\right).$$

Another example embodiment is given below to illustrate the operating principle and procedure of each of the above-described embodiments.

Example Embodiment II:

It should be noted that, in order to clearly explain the method of the embodiments of the present disclosure, a target to be positioned in this example is set as a base station to be positioned in a real indoor positioning environment, and the base station to be positioned is assumed to be a point for simplicity.

As shown in FIG. 9, in an indoor room, base station X to be positioned is located at a point on the wall surface, A and C are two corner points on the door frame of door 1, and B is a top corner point on the door frame of door 2.

First, indoor CAD drawing is utilized to selectively extract position parameters of an indoor wall line, a door, a column, a wall and the like to draw an indoor map.

Then, the wall surface on which X is located and two door frames of door 1 and door 2 are selected as reference objects, and a camera is set facing and in front of the wall line to take a photograph of base station X. During photographing, it needs to be ensured that the photograph includes X and completely includes all the reference objects, that is, the wall, door 1 and door 2.

Then, a captured photograph is processed, to be specific, information about the wall surface and each door frame is extracted, and the information is matched with that contained in the indoor map obtained in the first operation, to obtain a scale relationship between the reference objects in the photograph and reference objects in the indoor map. The matching here includes matching reference object information in the photograph and reference object information in the indoor map. Here, determining the scale relationship includes:

measuring a pixel point length of line section AC in the photograph, obtaining an actual length $m$ of line section AC according to the indoor map, and obtaining the scale relationship as f m/pixel point.

Then, a relative position parameter of base station X relative to the reference objects in the photograph is determined, that is, pixel lengths of line sections XA, XB and XC in the photograph are obtained, and the relative position parameter is g: XA, XB and XC (pixel points).

Then, an actual position of base station X in the indoor map is determined, that is, according to the relative position relationship g between base station X and the reference objects in the photograph, and the scale relationship /between the reference objects in the photograph and the reference objects in the indoor map, actual lengths of line sections XA, XB, and XC in the indoor map are determined, which is expressed as $f \cdot g(m)$. In other words, the actual position of base station X to be positioned in the indoor map can be determined by acquiring real position coordinates of points A, B, and C through the indoor map, in conjunction with geometric knowledge.

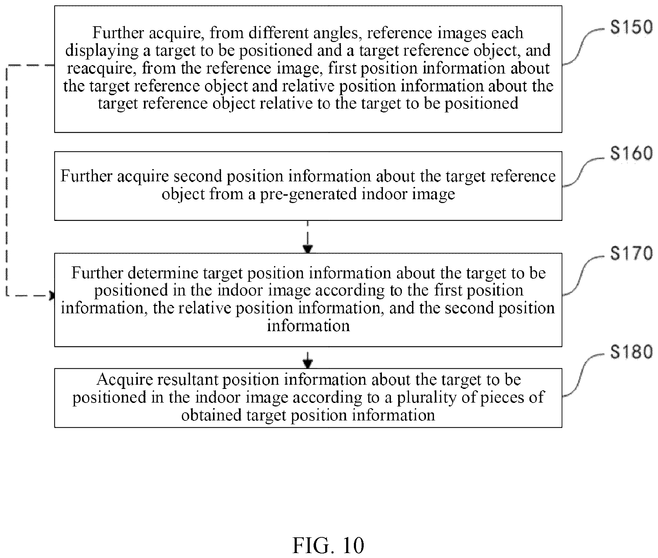

As shown in FIG. 10, an embodiment of the present disclosure also includes, but is not limited to, operations S150 to S180.

At operation S150, reference images each displaying the target to be positioned and the target reference object are additionally acquired from different angles, and first position information about the target reference object and relative position information about the target reference object relative to the target to be positioned are additionally acquired from the reference image.

At operation S160, second position information about the target reference object is additionally acquired from the pre-generated indoor image.

At operation S170, target position information about the target to be positioned in the indoor image is re-determined according to the first position information, the relative position information, and the second position information.

At operation S180, resultant position information about the target to be positioned in the indoor image is acquired according to a plurality of pieces of obtained target position information.

In this operation, considering that there may be some error in the target position information, of the target to be positioned in the indoor image, obtained by a single sampling calculation, in order to reduce the error, different reference images are obtained by additionally acquiring, from different angles, the reference images displaying the target to be positioned and the target reference object. Because the indoor image is generated and determined in advance, the target position information about the target to be positioned in the indoor image can be recalculated according to the indoor image and the acquired different reference images, so that a plurality of pieces of target position information about the target to be positioned in the indoor image can be obtained. Then, resultant position information about the target to be positioned in the indoor image can be acquired according to the obtained plurality of pieces of target position information. In this way, the acquired resultant position information about the target to be positioned in the indoor image is more accurate, which can reduce a possible measurement error caused by a fewer number of times of measurements.

In an embodiment, additionally acquiring, from different angles, reference images each displaying the target to be positioned and the target reference object may be, but is not limited to: as shown in S1121, taking a front photograph of the target to be positioned and the target reference object, or taking a side photograph of the target to be positioned and the target reference object, or taking a photograph of the target to be positioned and the target reference object from another preset angle, and the like, which is not limited herein.

In an embodiment, in addition to obtaining different reference images from different angles, it is possible, but is not limited to, changing a type, a quantity or the like of the target reference object to obtain different reference images, or using a way of obtaining different reference images selected by those having ordinary skill in the art according to a specific scenario, which is not limited herein.

In an embodiment, the number of times to determine the target position information about the target to be positioned in the indoor image is not limited. Generally, the determination is performed as many times as possible within a range of an affordable workload, to achieve an accurate calculation result of measurement.

In an embodiment, implementations of operations S150 to S170 are similar to implementations of operations S110 to S130.

The only difference is that angles by which the reference images are acquired are different, but this does not constitute a limitation of distinction on the methods for positioning of the two. Therefore, the implementations of operations S150 to S170 may refer to the implementations of operations S110 to S130. Since the implementations of operations S110 to S130 have been described in detail in the foregoing embodiments, the implementations of operations S150 to S170 will not be repeated here in order to avoid redundancy.

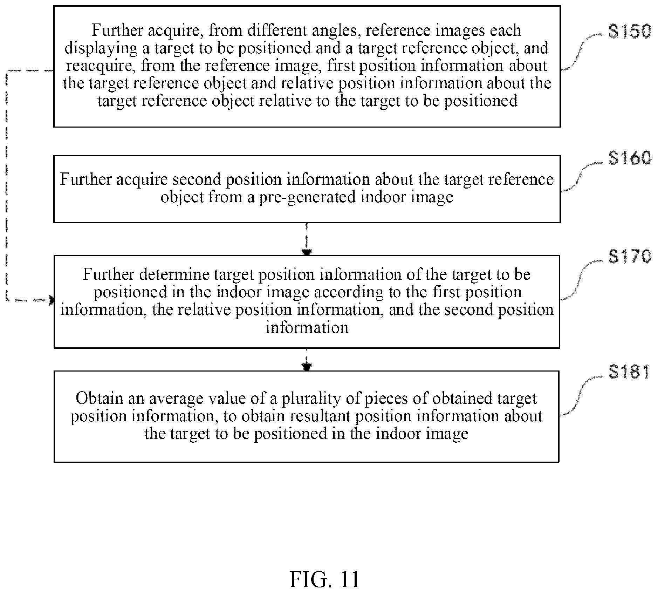

As shown in FIG. 11, in an embodiment of the present disclosure, operation S180 is further illustrated. Operation S180 further includes, but is not limited to, operation S181.

At operation S181, an average value of the plurality of pieces of obtained target position information is obtained, to obtain the resultant position information about the target to be positioned in the indoor image.

In this operation, when the plurality of pieces of target position information has been obtained, an average value calculation method is utilized. That is, by acquiring the average value of the plurality of pieces of target position information, the resultant position information about the target to be positioned in the indoor image under multiple measurements and calculations can be obtained. In other words, the average value of the plurality of pieces of target position information is served as a final value of the resultant position information about the target to be positioned in the indoor image. Thus it is possible to reduce a positioning error of the target to be positioned and to improve the positioning accuracy.

In an embodiment, in addition to the average value calculation method, it is possible, but is not limited to, using a method of variance calculation, standard deviation calculation, probability distribution calculation, or the like to obtain the resultant position information about the target to be positioned in the indoor image, which is not limited herein.

A specific example is given below to illustrate a working principle and procedure of each of the above-described embodiments.

Example Embodiment III:

It should be noted that, in order to illustrate in greater details the method of the embodiments of the present disclosure, a target to be positioned in this example is set as a base station to be positioned in a real indoor positioning environment, and the base station to be positioned is assumed to be a particle point for simplicity.

As shown in FIG. 8, in an indoor room, line section AB is a wall line, and base station X to be positioned is arranged along the wall line AB.

First, indoor CAD drawing is utilized to extract position parameters of an indoor wall line, a column, a wall, and the like to draw an indoor map.

Then, the wall line AB on which base station X is located is selected as a reference object, and a camera is set facing and in front of the wall line to take a photograph of base station X. During photographing, it needs to be ensured that the photograph includes X and includes the entire wall line AB along which base station X is arranged.

Then, a captured photograph is processed, to be specific, information about the wall line AB in the photograph is extracted, and the information is matched with that contained in the indoor map obtained in the first operation, to obtain a mapping relationship between the reference object in the photograph and a reference object in the indoor map. The matching here includes matching reference object information in the photograph and reference object information in the indoor map.

Then, a relative position parameter of X relative to the reference object in the photograph is determined, pixel lengths of line sections AX and XB in the photograph

$$\lambda = \frac{|AX|}{|AB|}$$

are obtained, and is defined as the relative position parameter of base station X along the wall line AB.

Then, an actual position of base station X in the indoor map is determined, that is, the actual position of base station X in the indoor map is acquired according to the relative position parameter of base station X relative to the reference object in the photograph and the mapping relationship between the reference object in the photograph and the reference object in the indoor map.

In an embodiment, $A(x_1, y_1)$ and $B(x_2, y_2)$ are given, and according to geometric knowledge, the actual position of base station X to be positioned in the indoor map can be expressed as follows:

$$X_i(x, y) = \left( \frac{x_1 + \lambda x_2}{1 + \lambda}, \frac{y_1 + \lambda y_2}{1 + \lambda} \right).$$

Then, base station X is photographed from different angles, and then the above operations in this Example Embodiment are repeated to obtain actual positions of base station X at different angles in the indoor map. The actual positions of base station X corresponding to the plurality of angles in the indoor map are averaged to obtain an average position of base station X to be positioned in the indoor map, and the average position is served as a final resultant position of base station X to be positioned in the indoor map, that is,

$$\overline{X}(x, y) = \sum_{i=1}^{N} X_i.$$

Another example embodiment is given below to illustrate a working principle and procedure of each of the above-described embodiments.

Example Embodiment IV:

It should be noted that, in order to illustrate in greater details the method of the embodiments of the present disclosure, a target to be positioned in this example is set as a base station to be positioned in a real indoor positioning environment, and the base station to be positioned is assumed to be a point for simplicity.

As shown in FIG. 9, in an indoor room, base station X to be positioned is located at a point on the wall surface, and points A and C, and B are corner points on two door frames, respectively.

First, indoor CAD drawing is used to extract position parameters of an indoor wall line, a door, a column, a wall and the like to draw an indoor map.

Then, the wall surface on which base station X is located and the two door frames are selected as reference objects, and a camera is set facing and in front of the wall line to take a photograph of X. During photographing, it needs to be ensured that the photograph includes X and completely includes all the reference objects.

Then, a captured photograph is processed, to be specific, information about the wall surface and the door frames is extracted, and the information is matched with that in the indoor map obtained in the first operation, to obtain a scale relationship between the reference objects in the photograph and reference objects in the indoor map. The matching here includes matching reference object information in the photograph and reference object information in the indoor map. Here, determining the scale relationship includes:

measuring a pixel point length of line section AC in the photograph, obtaining an actual length $m$ of line section AC according to the indoor map, and obtaining the scale relationship as $f$: $m$/pixel point.

Then, a relative position parameter of base station X relative to the reference objects in the photograph is determined, that is, pixel lengths of line sections XA, XB and XC in the photograph are obtained, and the relative position parameter is g: XA, XB and XC (pixel points).

Then, an actual position of base station X in the indoor map is determined, that is, according to the relative position relationship g between base station X and the reference objects in the photograph, and the scale relationship $f$ between the reference objects in the photograph and the reference objects in the indoor map, actual lengths of line sections XA, XB, and XC in the indoor map are determined, which is expressed as $f \cdot g(m)$. In other words, the actual position of base station X to be positioned in the indoor map can be determined by acquiring real position coordinates of points A, B, and C through the indoor map, combined with geometric knowledge.

Then, base station X is photographed from different angles, and then the above operations in this Example are repeated to obtain actual positions of base station X at different angles in the indoor map. The actual positions of base station X corresponding to the plurality of angles in the indoor map are averaged to obtain an average position of base station X to be positioned in the indoor map, and the average position is used as a final resultant position of base station X to be positioned in the indoor map.

Another example embodiment is given below to illustrate an overall working principle and procedure of the embodiments of the present disclosure.

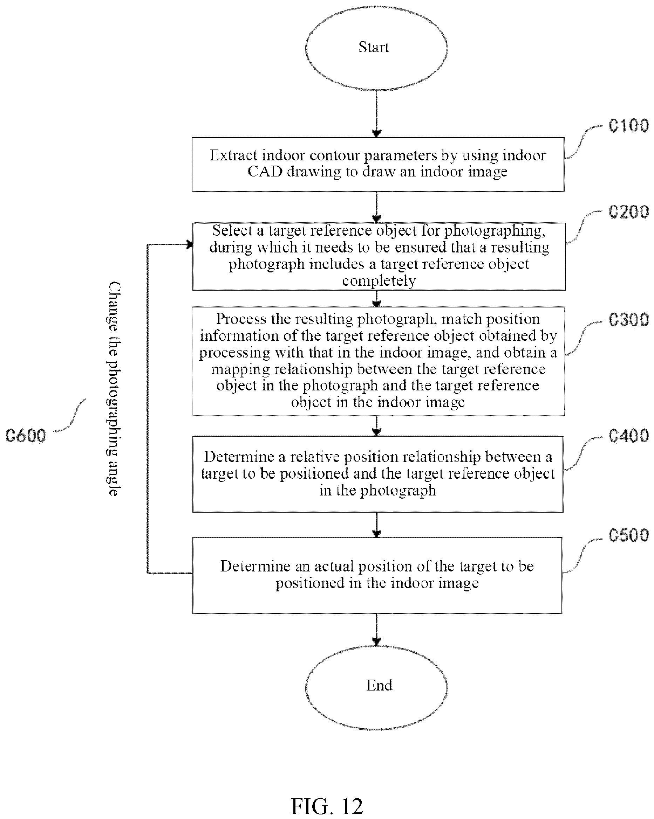

As shown in FIG. 12, a workflow of the embodiment of the present disclosure is implemented according to the following operations C100 to C600:

At operation C 100, indoor contour parameters are extracted by means of indoor CAD drawing to draw an indoor image, so as to further utilize the drawn indoor image for comparison and calculation.

At operation C200, a target reference object is selected for photographing, during which it needs to be ensured that a photograph includes the entire target reference object, such that the photograph can display both a target to be positioned and the target reference object, and position information about the target to be positioned and the target reference object can be accurately and reliably extracted from the photograph.

At operation C300, the resulting photograph is processed, the position information about the target reference object obtained by processing is matched with that in the indoor image, and a mapping relationship between the target reference object in the photograph and the target reference object in the indoor image is obtained, so as to further determine distinction parameters between the target reference object in the indoor image and the target reference object in the photograph based on the mapping relationship.

At operation C400, a relative position relationship between the target to be positioned and the target reference object in the photograph is determined, to further perform conversion calculation based on the relative position relationship.

At operation C500, an actual position of the target to be positioned in the indoor image is determined, thereby obtaining position information about the target to be positioned in the indoor image in a single time of positioning.

At operation C600, a photographing angle is changed, and the workflow proceeds to operation C200, and statistical position information about the target to be positioned in the indoor image in multiple times of positioning is obtained. Compared with the single time of positioning for calculation of the position information, the multiple times of positioning can effectively reduce a possible error in the single time of positioning and improve positioning accuracy.

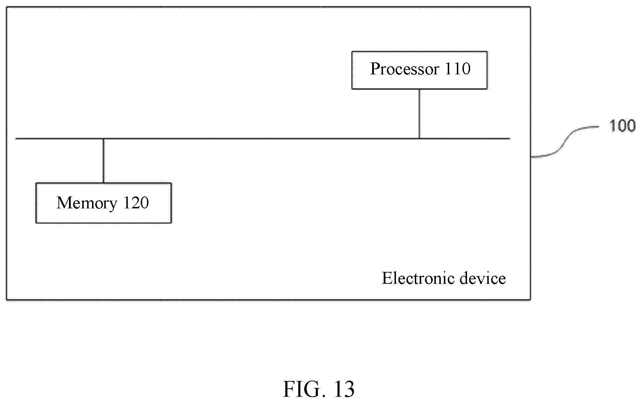

In addition, as shown in FIG. 13, a further embodiment of the present disclosure discloses an electronic device 100, including: at least one processor 110; at least one memory 120 for storing at least one program, where the at least one program, when executed by the at least one processor 110, causes the at least one processor to carry out the method of any one of the foregoing embodiments.

In addition, a further embodiment of the present disclosure discloses a computer-readable storage medium storing computer-executable instructions for performing the method of any one of the foregoing embodiments.

Additionally, a further embodiment of the present disclosure discloses a computer program product, including a computer program or computer instructions, where the computer program or the computer instructions are stored in a computer-readable storage medium, a processor of a computer device reads the computer program or the computer instructions from the computer-readable storage medium, and the computer program or the computer instructions, when executed by the processor, cause the computer device to perform the method as described in any of the previous embodiments.

It can be understood by those of ordinary skill in the art that all or some of the operations of the methods and systems disclosed above may be implemented as software, firmware, hardware, and appropriate combinations thereof. Some or all of the physical components may be implemented as software executed by a processor, such as a central processing unit, a digital signal processor or a microprocessor, or as hardware, or as an integrated circuit, such as an application-specific integrated circuit. Such software may be distributed on computer-readable media, which may include computer-readable storage media (or non-transitory media) and communication media (or transitory media). As well known to those of ordinary skill in the art, the term computer-readable storage medium includes volatile and nonvolatile, removable and non-removable media implemented in any method or technique for storing information, such as computer-readable instructions, data structures, program modules or other data. A computer-readable storage medium includes but is not limited to a random access memory (RAM), a read-only memory (ROM), an electrically erasable programmable read-only memory (EEPROM), a flash memory or other memory techniques, a compact disc read-only memory (CD-ROM), a digital versatile disk (DVD) or other optical disk storage, a magnetic cassette, a magnetic tape, magnetic disk storage or other magnetic storage devices, or any other medium that can be used to store desired information and can be accessed by a computer. Furthermore, it is well known to those of ordinary skill in the art that communication media typically contain computer-readable instructions, data structures, program modules or other data in a modulated data signal such as a carrier wave or other transmission mechanism, and may include any information transmission media.

**Claims**

1. A method for positioning, comprising:

   acquiring a reference image displaying both a target to be positioned and at least one target reference object, acquiring first position information about the target reference object within the reference image, and acquiring relative position information about the target to be positioned relative to the target reference object, in the reference image;
   acquiring second position information about the target reference object in a pre-generated indoor image; and
   determining target position information about the target to be positioned in the indoor image according to the first position information, the relative position information, and the second position information.

2. The method of claim 1, wherein determining the target position information about the target to be positioned in the indoor image according to the first position information, the relative position information, and the second position information comprises:
   determining the target position information about the target to be positioned in the indoor image through geometric calculation according to the first position information, the relative position information, and the second position information.

3. The method of claim 2, wherein determining the target position information about the target to be positioned in the indoor image through geometric calculation according to the first position information, the relative position information, and the second position information comprises:

   determining reference mapping information between the target reference object in the reference image and the target reference object in the indoor image according to the first position information and the second position information; and
   determining the target position information about the target to be positioned in the indoor image through geometric calculation according to the first position information, the second position information, the reference mapping information, and the relative position information.

4. The method of claim 3, wherein determining the target position information about the target to be positioned in the indoor image through geometric calculation according to the first position information, the second position information, the reference mapping information, and the relative position information comprises:

   determining first position coordinates of the target reference object according to the first position information, determining a relative position parameter which corresponds to the target reference object according to the relative position information, and determining second position coordinates of the target reference object according to the second position information; and calculating the first position coordinates, the second position coordinates, the reference mapping information, and the relative position parameter through geometric calculation to obtain the target position information about the target to be positioned in the indoor image.

5. The method of claim 1, further comprising:

   further acquiring, from different angles, additional reference images each displaying both the target to be positioned and the target reference object, and further acquiring, from the additional reference images, additional pieces of first position information about the target reference object and additional pieces of relative position information about the target reference object relative to the target to be positioned;
   further acquiring additional pieces of second position information about the target reference object from the pre-generated indoor image;
   further determining additional pieces of target position information about the target to be positioned in the indoor image according to the additional pieces of first position information, the additional pieces of relative position information, and the additional pieces of second position information; and

acquiring resultant position information about the target to be positioned in the indoor image according to the obtained additional pieces of target position information and the target position information.

6. The method of claim 5, wherein acquiring resultant position information about the target to be positioned in the indoor image according to the obtained additional pieces of obtained target position information and the target position information comprises:

obtaining an average value of the obtained additional pieces of target position information and the target position information, to obtain the resultant position information about the target to be positioned in the indoor image.

7. The method of claim 1, wherein acquiring the reference image displaying both the target to be positioned and the at least one target reference object comprises:

identifying the at least one target reference object positioned within the same plane as the target to be positioned; and
photographing the target to be positioned and the at least one target reference object to obtain the reference image displaying both the target to be positioned and the target reference object.

8. The method of claim 7, wherein photographing the target to be positioned and the at least one target reference object to obtain the reference image displaying both the target to be positioned and the target reference object comprises:

taking a front photograph of the target to be positioned and the at least one target reference object to obtain the reference image displaying both the target to be positioned and the target reference object.

9. The method of claim 1, wherein acquiring the relative position information about the target to be positioned relative to the target reference object in the reference image comprises:

acquiring pixel coordinate information about the target reference object and pixel coordinate information about the target to be positioned from the reference image; and
determining, according to the pixel coordinate information about the target reference object and the pixel coordinate information about the target to be positioned, relative position information about the target reference object relative to the target to be positioned.

10. The method of claim 1 or 9, wherein the relative position information comprises at least one of:

a distance between the target reference object and the target to be positioned; or
a relative position of the target reference object relative to a target projection, wherein the target projection is a projection of the target to be positioned onto the target reference object.

11. The method of claim 1, wherein the first position information comprises at least one of:

physical coordinate information about the target reference object within the reference image; or
pixel coordinate information about the target reference object within the reference image.

12. The method of claim 1, wherein the second position information comprises at least one of:

physical coordinate information about the target reference object within the indoor image; or
pixel coordinate information about the target reference object within the indoor image.

13. The method of claim 3 or 4, wherein the reference mapping information comprises at least one of:

scale relationship; or
projection relationship.

14. The method of claim 1, wherein before acquiring the reference image displaying both the target to be positioned and the at least one target reference object, the method further comprises:
selecting the at least one target reference object from the indoor image.

15. The method of claim 1, wherein the indoor image is generated based on:

acquiring an indoor position parameter of indoor space; and
generating the indoor image according to the indoor position parameter, wherein the indoor image corresponds to the indoor space.

16. The method of claim 15, wherein the indoor position parameter comprises at least one of:

a wall line position parameter;
a door position parameter;
a stand column position parameter;
a wall position parameter; or
a window position parameter.

17. An electronic device, comprising:

at least one processor; and
at least one memory for storing at least one program which, when executed by the at least one processor, causes the at least one processor to carry out the method of any one of claims 1 to 16.

18. A computer-readable storage medium storing an executable program which, when executed by a processor, causes the processor to carry out the method of any one of claims 1 to 16.

19. A computer program product, comprising a computer program or computer instructions stored in a computer-readable storage medium, from which a processor of a computer device reads the computer program or the computer instructions, wherein the computer program or the computer instructions, when executed by the processor, cause the computer device to carry out the method of any one of claims 1 to 16.

Acquire a reference image displaying both a target to be positioned and at least one target reference object, acquire first position information about the target reference object in the reference image, and acquire relative position information about the target to be positioned relative to the target reference object in reference image —— S110

Acquire second position information about the target reference object in a pre-generated indoor image —— S120

Determine target position information about the target to be positioned in the indoor image according to the first position information, the relative position information, and the second position information —— S130

FIG. 1

Determine at least one target reference object located in the same plane as a target to be positioned —— S111

Photograph the target to be positioned and the at least one target reference object to obtain a reference image displaying the target to be positioned and the target reference object —— S112

FIG. 2

| Determine at least one target reference object located in the same plane as a target to be positioned | S111 |

| Take a front photograph of the target to be positioned and the at least one target reference object to obtain a reference image displaying the target to be positioned and the target reference object | S1121 |

FIG. 3

| Acquire pixel coordinate information about a target reference object and pixel coordinate information about a target to be positioned from a reference image | S113 |

| Determine, according to the pixel coordinate information about the target reference object and the pixel coordinate information about the target to be positioned, relative position information about the target reference object relative to the target to be positioned | S114 |

FIG. 4

| Acquire an indoor position parameter of indoor space | S200 |

| Generate, according to the indoor position parameter, an indoor image corresponding to the indoor space | S300 |

FIG. 5

| Determine reference mapping information between a target reference object in a reference image and the target reference object in an indoor image according to first position information and second position information | S1311 |

| Determine target position information of a target to be positioned in the indoor image through geometric calculation according to the first position information, the second position information, the reference mapping information, and relative position information | S1312 |

FIG. 6

| Determine first position coordinates of a target reference object according to first position information, determine a relative position parameter which corresponds to the target reference object according to relative position information, and determine second position coordinates of the target reference object according to second position information | S13121 |

| Calculate the first position coordinates, the second position coordinates, reference mapping information, and the relative position parameter through geometric calculation to obtain target position information of a target to be positioned in an indoor image | S13122 |

FIG. 7

FIG. 8

FIG. 9

Further acquire, from different angles, reference images each displaying a target to be positioned and a target reference object, and reacquire, from the reference image, first position information about the target reference object and relative position information about the target reference object relative to the target to be positioned — S150

Further acquire second position information about the target reference object from a pre-generated indoor image — S160

Further determine target position information about the target to be positioned in the indoor image according to the first position information, the relative position information, and the second position information — S170

Acquire resultant position information about the target to be positioned in the indoor image according to a plurality of pieces of obtained target position information — S180

FIG. 10

Further acquire, from different angles, reference images each displaying a target to be positioned and a target reference object, and reacquire, from the reference image, first position information about the target reference object and relative position information about the target reference object relative to the target to be positioned ⟋ S150

Further acquire second position information about the target reference object from a pre-generated indoor image ⟋ S160

Further determine target position information of the target to be positioned in the indoor image according to the first position information, the relative position information, and the second position information ⟋ S170

Obtain an average value of a plurality of pieces of obtained target position information, to obtain resultant position information about the target to be positioned in the indoor image ⟋ S181

FIG. 11

Start

Extract indoor contour parameters by using indoor CAD drawing to draw an indoor image — C100

Select a target reference object for photographing, during which it needs to be ensured that a resulting photograph includes a target reference object completely — C200

Process the resulting photograph, match position information of the target reference object obtained by processing with that in the indoor image, and obtain a mapping relationship between the target reference object in the photograph and the target reference object in the indoor image — C300

Determine a relative position relationship between a target to be positioned and the target reference object in the photograph — C400

Determine an actual position of the target to be positioned in the indoor image — C500

Change the photographing angle — C600

End

FIG. 12

FIG. 13

<div align="center">**INTERNATIONAL SEARCH REPORT**</div>

| International application No. |
|---|
| **PCT/CN2023/073002** |

**A. CLASSIFICATION OF SUBJECT MATTER**

G06T 7/70(2017.01)i

According to International Patent Classification (IPC) or to both national classification and IPC

**B. FIELDS SEARCHED**

Minimum documentation searched (classification system followed by classification symbols)

IPC: G06T

Documentation searched other than minimum documentation to the extent that such documents are included in the fields searched

Electronic data base consulted during the international search (name of data base and, where practicable, search terms used)

CNABS, VEN, CNTXT, WOTXT, EPTXT, USTXT, CNKI, IEEE: 室内, 定位, 目标, 参照, 参考, 位置, 相对位置, 图像, indoor, locat+, target, objective, reference, postion+, relative location, image

**C. DOCUMENTS CONSIDERED TO BE RELEVANT**

| Category* | Citation of document, with indication, where appropriate, of the relevant passages | Relevant to claim No. |
|---|---|---|
| X | CN 110443850 A (ZHUHAI UNITECH POWER TECHNOLOGY CO., LTD.) 12 November 2019 (2019-11-12) description, paragraphs [0048]-[0115], and figures 1-16 | 1-19 |
| A | CN 112348909 A (BEIJING SENSETIME SCIENCE TECHNOLOGY DEVELOPMENT CO., LTD.) 09 February 2021 (2021-02-09) entire document | 1-19 |
| A | CN 113804100 A (HUAWEI TECHNOLOGIES CO., LTD.) 17 December 2021 (2021-12-17) entire document | 1-19 |
| A | JP 2019125227 A (OSENSE TECHNOLOGY CO., LTD.) 25 July 2019 (2019-07-25) entire document | 1-19 |

☐ Further documents are listed in the continuation of Box C.  ☑ See patent family annex.

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "D" document cited by the applicant in the international application | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **07 March 2023** | **14 March 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

International application No.

**PCT/CN2023/073002**

| Patent document cited in search report | | | Publication date (day/month/year) | Patent family member(s) | Publication date (day/month/year) |
|---|---|---|---|---|---|
| CN | 110443850 | A | 12 November 2019 | None | |
| CN | 112348909 | A | 09 February 2021 | None | |
| CN | 113804100 | A | 17 December 2021 | None | |
| JP | 2019125227 | A | 25 July 2019 | None | |

Form PCT/ISA/210 (patent family annex) (July 2022)

**EP 4 502 947 A1**

**Patent documents cited in the description**

- CN 202210608266